# EUROPÄISCHE PATENTSCHRIFT

(11) **EP 2 983 286 B1**
(45) Veröffentlichungstag und Bekanntmachung des Hinweises auf die Patenterteilung: **27.06.2018**
(21) Anmeldenummer: 14180323.9
(22) Anmeldetag: 08.08.2014
(51) Int. Cl.: H02M 7/483, H01H 33/66, H01H 39/00

(54) **Submodul für eine modulare Stromrichterschaltung**
Sub-module for a modular power converter
Sous-module pour un circuit de convertisseur modulaire

(43) Veröffentlichungstag der Anmeldung: 10.02.2016
(73) Patentinhaber: Siemens Aktiengesellschaft, 80333 München (DE)
(72) Erfinder: Pfauser, Anton, 96178 Pommersfelden (DE); Wald, Alois, 91325 Adelsdorf (DE)

(56) Entgegenhaltungen:
- WO-A1-2011/154047
- DE-B3-102008 059 670
- US-A1- 2011 057 762
- US-A1- 2012 112 545

## Beschreibung

Die Erfindung betrifft ein Submodul insbesondere für einen modularen Multilevel-Stromrichter welches eine erste Eingangsklemme und eine zweite Eingangsklemme aufweist.

In der Leistungselektronik nehmen Umrichter bei der Übertragung von Energie eine zentrale Rolle ein. Ebenso ist in vielen Bereichen der Industrie, so beispielsweise die Herstellung von Transportmitteln, die technologische Entwicklung mit der Verfügbarkeit von effizienten und leistungsstarken Umrichtern verbunden.

Gerade bei der Einspeisung von Energie in ein Stromnetz in Betrieb, aber auch für eine möglichst verlustfreie Energieübertragung sind die Qualität und die Stabilität der von einem Umrichter bereitgestellten Spannung wesentlich. Besonders im Mittelspannungsbereich haben sich zu diesem Zweck in letzter Zeit modulare Umrichter etabliert. Diese finden ihren Einsatz u.a. auch bei drehzahlveränderlichen Antriebssystemen. Andere Anwendungen sind der Einsatz dieser Technik in so genannten Wellengenerator-Anlagen zur Bordnetzversorgung beispielsweise auf Schiffen. In einem solchen modularen Umrichter wird jeweils ein Phasenstrang durch eine Mehrzahl von zueinander eingangsseitig in Reihe geschalteten Submodulen gebildet, welche jeweils dazu ausgelegt sind, eine Teilspannung der gewünschten Ausgangsspannung bereitzustellen. Durch Schaltvorgänge in den einzelnen Submodulen können diese ihre entsprechende Teilspannung entweder an eine Ausgangsklemme anlegen, oder überbrückt werden. Insbesondere zur Erzeugung bzw. Einspeisung sinusförmiger Wechselspannungen ist in diesem Zusammenhang die Topologie des modularen Multilevel-Stromrichters zu nennen, wie sie beispielsweise in einem SINAMICS SM120- oder einem SINAMICS GH150-Umrichter von Siemens realisiert ist.

Aufgrund der eingangsseitigen Reihenschaltung einzelner Submodule kann ein Fehler in einem Submodul, beispielsweise ein Defekt in einem Schalter, zu einer Störung des Betriebs des ganzen Umrichters führen. Deshalb ist in vielen Topologien modularer Umrichter die Möglichkeit vorgesehen, ein einzelnes Submodul in einem wie auch immer gearteten Fehlerfall eingangsseitig kurzzuschließen, und somit dauerhaft zu überbrücken, so dass der Fehler den Betrieb des Umrichters möglichst nicht weiter beeinträchtigt. Gerne wird hierfür bei vielen Umrichterkonzepten in jedem Submodul ein zusätzlicher elektromagnetischer Kurzschlussschalter eingesetzt. Ein solches System benötigt meist eine Fremdversorgung, über welche beispielsweise für den Betrieb des Umrichters die Energie in die einzelnen Submodule gespeist wird. Die Fremdversorgung kann dann auch die Ansteuerleistung und die Halteleistung für die Kurzschlussschalter der Submodule zur Verfügung stellen. Sieht das Umrichtersystem hingegen keine Fremdversorgung für die Submodule vor, ist eine Sicherung im Fehlerfall über Kurzschlussschalter nur unter erheblichem Mehraufwand im System zu realisieren.

Insbesondere bei einem Umrichter, welcher aufgrund seiner Positionierung oder seiner Anwendung schwer zu warten ist, also beispielsweise ein Umrichter in einem Offshore-Windrad oder auf einem Hochseeschiff, kann ein Fehler in einem Submodul oft erst nach verhältnismäßig langem Betrieb behoben werden. Ebenso ist oftmals eine Korrosion der Kontakte des Kurzschlussschalters nicht zu vermeiden, wodurch dessen Lebensdauer verringert wird. Gerade bei den genannten schwer zu wartenden Umrichtern könnte sich dies als ein erheblicher Nachteil erweisen.

Da insbesondere Umrichter, welche zur Netzeinspeisung eingesetzt werden, häufig einem umfangreichen Genehmigungsverfahren unterworfen sind, bei welchem oftmals auch einzelne Komponenten von einer entsprechenden Prüfbehörde abzunehmen sind, ergibt sich somit der Wunsch, bei einer Anpassung eines bestehenden Konzeptes möglichst wenige der Komponenten zu verändern. Dies ist umso mehr der Fall, wenn angestrebt werden soll, bereits in Betrieb genommene Umrichter nachzurüsten.

Die Offenlegungsschrift WO 2011/154047 A1 offenbart einen Umrichter mit in Reihe geschalteten zweipoligen Submodulen, die jeweils einen Energiespeicher und eine Leistungshalbleiterschaltung mit ein- und abschaltbaren Leistungshalbleitern aufweisen. Die Leistungshalbleiterschaltung ist so mit dem Energiespeicher verbunden, dass an Anschlussklemmen jedes Submoduls die an dem Energiespeicher abfallende Spannung oder aber eine Nullspannung erzeugbar ist. Eine Regelungseinheit ist mit den Leistungshalbleitern zum Ein- und Abschalten verbunden und mechanische Schalter sind parallel zu jedem Submodul zum Überbrücken des zugeordneten Submoduls angeordnet.

Die Patentschrift DE 10 2008 059 670 B3 offenbart einen Vakuumschalter mit einer Vakuumkammer, in der ein Vakuum herrscht und in der ein Schaltkontakt angeordnet ist, der ein fest mit der Vakuumkammer verbundenes Festkontaktstück, und ein bezüglich des Festkontaktstückes beweglich geführtes Bewegkontaktstück aufweist. Ferner wird ein Umrichterventil mit einer Reihenschaltung von bipolaren Submodulen offenbart, wobei jedes Submodul wenigstens einen Energiespeicher und eine Leistungshalbleiterschaltung aufweist, mit der die an dem Energiespeicher abfallende Spannung oder eine Nullspannung an dem Anschluss des zugeordneten Submoduls erzeugbar ist. Jedem Submodul sind Überbrückungsmittel zum Überbrücken des Submoduls im Fehlerfall zugeordnet, wobei die Überbrückungsmittel einen derartigen Vakuumschalter aufweisen.

Die Offenlegungsschrift US 2012/0112545 A1 offenbart ein modulares Mulitlevel-Umrichter-System, welches eine Vielzahl von in Serie geschalteten modularen Mulitlevel-Umrichter-Zellen aumfasst. Mindestens eine der modularen Mulitlevel-Umrichter-Zellen ist ein 3-Level modularer Mulitlevel-Umrichter.

Die Offenlegungsschrift US 2011/0057762 A1 offenbart eine Kurzschlussvorrichtung zum elektrischen Überbrücken eines Elektromoduls mit einer in einer Schaltkammer angeordneten Kontaktanordnung, die eine Unterbrecherstellung und eine Kontaktstellung aufweist. Ein pyrotechnischer Antrieb überführt die Kontaktanordnung von der Unterbrecherstellung in die Kontaktstellung. Die Schaltkammer ist eine Vakuumschaltkammer, in der ein Vakuum herrscht.

Der Erfindung liegt daher die Aufgabe zugrunde, ein Submodul insbesondere für einen modularen Multilevel-Stromrichter anzugeben, welches im Fall eines Fehlers auf möglichst einfache Art und ohne nennenswerte Leistungsverluste einen weiteren Betrieb des Stromrichters erlauben soll.

Die Aufgabe wird durch die Merkmale des Vorrichtungsanspruchs 1 gelöst. Die abhängigen Ansprüche definieren vorteilhafte Ausgestaltungen der Erfindung. Der Erfindung liegen hierbei folgende Überlegungen zugrunde: Um für einen modularen Stromrichter die Betriebsfähigkeit zu verbessern, wird zunächst erkannt, dass eine Schaltung, welche dazu eingerichtet ist, einen innerhalb eines Submoduls auftretenden Fehler wie beispielsweise eine Überspannung unmittelbar am Entstehungsort zu korrigieren, aufgrund der verschiedenen Fehlermöglichkeiten und der dadurch erhöhten notwendigen Komplexität einer derartigen Schaltung bevorzugt zu vermeiden ist. Dabei wird erkannt, dass es trotz der offensichtlichen Probleme mit bisherigen Überbrückungsschaltungen vorteilhafter ist, die modulare Topologie eines Umrichters für ein gezieltes Überbrücken eines bestimmten Submoduls, in welchem der Betrieb fehlerhaft ist, zu nutzen, um den Betrieb des Umrichters aufrecht zu erhalten. Eine submodul-interne Fehlerbehebung wird somit aufgrund des steuerungstechnischen Mehraufwandes verworfen.

Um nun ein fehlerhaftes Submodul überbrücken zu können, wäre zunächst zu bedenken, dass ein Submodul im Normalfall Schaltmittel aufweist, welche oftmals durch Halbleiterschalter realisiert sind, um einzelne Spannungsstufen bzw. Teilspannungen der angeforderten Gesamtspannung bereitzustellen, und durch diese Schaltmittel auch im Normalbetrieb überbrückt wird, wenn eine Spannungsstufe des Submoduls in einem bestimmten Schaltzyklus nicht erforderlich ist. Nun wird jedoch erkannt, dass eine Überbrückung eines fehlerhaften Submoduls über derartige Schaltmittel möglicherweise nicht die gewünschte Betriebssicherheit bietet, da man hierfür auf Schaltmittel in einem Submodul zurückgreifen würde, in welchem der Betrieb bereits fehlerhaft ist, und somit auch ein Fehler beim Überbrücken nicht gänzlich ausgeschlossen werden kann. Dies könnte beispielsweise zur Folge haben, dass eine Überspannung in einem Submodul nicht auf dieses beschränkt bliebe, sondern bei einer fehlerhaften Überbrückung auch andere Submodule davon betroffen sein könnten.

Während bei einem wegen eines derartigen Fehlers überbrückten Submoduls allenfalls dort dauerhafte Beschädigungen durch die Überspannungen zu befürchten wären, könnte also eine Überbrückung, welche sich der Schaltmittel und ggf. der Steuereinheit eines bereits fehlerhaften Submoduls bedient, die topologische Isolierung einer Gefahr nicht sicher gewährleisten.

Die Verwendung eines der vorhandenen, als Halbleiterschalter ausgebildeten Schaltmittel hätte bei zudem selbst im Falle einer fehlerfreien Überbrückung zur Folge, dass der Halbleiterschalter zum dauerhaften Schließen konstant eine Ansteuer- und/oder Halteleistung erfordern würde. Dies würde die Effizienz eines Stromrichters im Falle eines fehlerhaften Submoduls dauerhaft - bis zur endgültigen Behebung des Fehlers - erheblich verringern. Dieses Problem tritt auch bei einem eigens für die Überbrückung vorgesehenen Halbleiterschalter oder einem Schütz auf, welche im Normalbetrieb keine weitere Funktion einnehmen.

Ein Bypassschalter, welcher im Fehlerfall eines Submoduls mittels eines pyrotechnischen Kraftelements das Submodul an seinen Eingangsklemmen überbrückt, weist gegenüber den genannten Vorgehensweisen nun folgende entscheidenden Vorteile auf: Durch das umgehende, endgültige Schließen des Schaltweges ist das Submodul an seinen beiden Eingangsklemmen dauerhaft kurzgeschlossen, ohne dass eine entsprechende dauerhafte Ansteuer- und/oder Halteleistung erforderlich wird. Für einen derartigen Bypassschalter muss zudem ein konstruktives Design eines bestehenden Submoduls nur geringfügig angepasst werden, was sowohl für die Integration in bereits bestehende Konzepte bzw. die Nachrüstung bestehender Anlagen als auch für Genehmigungsverfahren vor technischen Prüfbehörden von Vorteil ist.

Insbesondere kann dabei der Bypassschalter so ausgestaltet sein, dass er baulich vollständig von den Schaltmitteln im Submodul getrennt ist, was eine derartige Nachrüstung vereinfacht, da hierfür keine Veränderung an den Platinen, auf welchen die Schaltmittel aufgebracht sind, erforderlich werden. Zum Austausch eines ausgelösten Bypassschalters ist der Stromrichter aus Sicherheitsgründen bevorzugt außer Betrieb, insbesondere vom Netz zu nehmen, und zu erden. Danach kann im Submodul eine Bauteileinheit, welche einen Defekt aufweist, beispielsweise eine Schalterplatine oder eine Kondensatorbatterie, in welcher die Kapazitäten eines Submoduls angeordnet sind, ersetzt werden, und anschließend ein neuer Bypassschalter eingesetzt werden. Dies kann bei einer so genannten Anlagenrevision erfolgen.

Vorzugsweise kann hierbei ein Bypassschalter verwendet werden, welcher infolge einer anderweitigen Anwendung bereits die für den entsprechenden Markt nötigen Zertifizierungs- und Genehmigungsverfahren durchlaufen hat. Insbesondere infolge des pyrotechnischen Kraftelements in Verbindung mit der Mittelspannung des Stromrichters kann der Bypassschalter ggf. besonderen Sicherheitsauflagen bei besagter Zertifizierung und/oder Genehmigung unterliegen. Die Verwendung eines bereits behördlich genehmigten Bypassschalters kann daher vorteilhaft sein. Günstigerweise sollte in diesem Fall auf einen solchen Bypassschalter zurückgegriffen werden, welcher möglichst geringe Veränderungen an der Konstruktion und der internen Elektronik eines Submoduls erfordert.

Bevorzugt umfasst der Bypassschalter eine Vakuumschaltröhre, durch welche der Schaltweg im Bypassschalter schließbar ist. Durch das Vakuum werden die Schaltkontakte der Vakuumschaltröhre vor äußeren Einflüssen, insbesondere vor Korrosion, geschützt. Dadurch weist die Vakuumschaltröhre über ihre Betriebsdauer konstante Eigenschaften auf, was zu einer besonderen Verlässlichkeit des Bypassschalters führt. Insbesondere in Anwendungen, bei welchen eine Vakuumschaltröhre Strömen bis zu 1500A ausgesetzt ist, ist ein Einsatz aufgrund der verfügbaren Technologien vorteilhaft.

Als ebenfalls vorteilhaft erweist es sich, wenn der Bypassschalter wenigstens zwei redundante Zündkreise zum Zünden des pyrotechnischen Kraftelements aufweist. Zwei redundante Zündkreise zum Zünden des pyrotechnischen Kraftelements stellen zunächst einmal einen erhöhten Systemaufwand dar. Dies ist a priori unerwünscht, insbesondere bei einem größeren Stromrichter mit einer Vielzahl von Submodulen. Eine wichtige Erkenntnis ist nun jedoch, dass es für ein zentrales Ziel der Bypassschaltung, nämlich ein möglichst verlässliches Kurzschließen eines Submoduls im Fehlerfall, dennoch günstiger sein kann, diese erhöhte Komplexität in Kauf zu nehmen, um in einem Fehlerfall eine besonders hohe Sicherheit zu genießen. Dies gilt insbesondere angesichts der Tatsache, dass einerseits ein Fehler im schlimmsten Fall auch einen der Zündkreise in Mitleidenschaft ziehen könnte, jedoch andererseits ein Übergreifen auf zwei vollständig voneinander getrennte Zündkreise als sehr unwahrscheinlich einzustufen ist. Bevorzugt sind hierbei die getrennten Zündkreise jeweils durch separate Steuerkanäle von einer entsprechenden Steuerplatine anzusteuern.

Als weiter vorteilhaft erweist es sich, wenn das Submodul und der Bypassschalter jeweils eine Steuerplatine umfassen, wobei die Steuerplatine des Bypassschalters über wenigstens zwei redundante Steuerkanäle von der Steuerplatine des Submoduls angesteuert werden kann. Gerade für eine submodul-interne Fehlererfassung über eine entsprechende Steuerplatine des Submoduls, welche im Fehlerfall ein Anweisung zum Überbrücken des Moduls auszugeben hat, ist es günstig, eine Steuerplatine des Bypassschalters, von welchem aus das pyrotechnische Kraftelement zu zünden ist, über zwei verschiedene, zueinander redundante Steuerkanäle anzusteuern. Dies erhöht die Verlässlichkeit des Bypassschalters für den Fall, dass ein Steuerkanal zur Steuerplatine des Bypassschalters durch einen Frühausfall eines Bauteils nicht mehr zündfähig ist. Die Wahrscheinlichkeit, dass beide Steuerkanäle gleichzeitig ausfallen, kann hierbei als für einen ausreichend sicheren Betrieb vernachlässigbar gering eingestuft werden. Insbesondere kann hierbei je ein Steuerkanal von der Steuerplatine des Submoduls über die Steuerplatine des Bypassschalters jeweils einen Zündkreis ansteuern, wodurch zwei vollständig voneinander getrennte Steuerkanal-Zündkreis-Systeme gebildet werden.

Zweckmäßiger Weise umfasst das Submodul eine erste Halbbrücke und eine erste Kapazität, wobei die erste Halbbrücke eingangsseitig mit der ersten Eingangsklemme und ausgangsseitig mit der ersten Kapazität verschaltetet ist. Unter einer Verschaltung ist hierbei und im Folgenden zu verstehen, dass ein Schaltweg existiert, d.h., dass eine leitende Verbindung vorhanden ist, welche ggf. durch einen Schalter unterbrochen werden kann. Für Topologien der angegebenen Art ist der genannte Bypassschalter eine besonders vorteilhafte Möglichkeit, ein Submodul im Fehlerfall zu überbrücken.

Bevorzugt umfasst das Submodul hierbei eine zweite Halbbrücke und eine zweite Kapazität, wobei die zweite Halbbrücke eingangsseitig mit der zweiten Eingangsklemme und ausgangsseitig mit der zweiten Kapazität derart verschaltetet ist, dass durch einen gemeinsamen Schaltzustand der ersten Halbbrücke und der zweiten Halbbrücke die erste Kapazität und die zweite Kapazität in Reihe zur ersten Eingangsklemme und zur zweiten Eingangsklemme schaltbar sind. Die Verschaltung einer Halbbrücke mit den beiden Eingangsklemmen des Submoduls kann dabei ggf. über einen oder beide Schalter der jeweils anderen Halbbrücke führen. Eine solche Topologie findet sich häufig in Anwendungen im Mittelspannungsbereich, beispielsweise in Stromrichtern für Windkraftanlagen. Eine derartige Ausgestaltung der Submodule vereinfacht in einem Stromrichter ihre Ansteuerung, da ein Steuerkanal von einer übergeordneten Steuereinheit des Stromrichters zu einem Submodul bevorzugt potentialgetrennt zu realisieren ist und daher oftmals über ein optisches Signalkabel implementiert wird. Durch die beschriebene Doppelsubmodul-Struktur können in einem bevorzugt potentialgetrennt anzusteuernden Submodul effektiv zwei der Spannungsstufen des Stromrichters bereitgestellt werden.

Bevorzugt sind der Bypassschalter und seine Komponenten, so beispielsweise ggf. eine Vakuumschaltröhre, auf die Topologie des Submoduls und insbesondere auf die dort im Betrieb des Umrichters auftretenden Ströme abzustimmen. Dies erlaubt, dass entsprechende Komponenten so ausgelegt werden, dass sie den im Betrieb zu erwartenden Belastungen stand halten, jedoch insbesondere nicht überdimensioniert sind. Werden beispielsweise in einem Stromrichter für Mittelspannungs-Anwendungen die Spannungsstufen über Doppelsubmodule der vorbeschriebenen Art bereitgestellt, treten im Betrieb für gewöhnlich Ströme auf, welche 1500A nicht überschreiten. Dementsprechend brauchen der Bypass und seine Komponenten nicht für erheblich höhere Ströme ausgelegt zu werden.

Günstiger Weise ist der Bypassschalter dazu eingerichtet, beim Zünden des pyrotechnischen Kraftelements wenigstens ein Zündsignal an eine übergeordnete Steuerung des Stromrichters auszusenden. Das Zündsignal wird dabei ggf. über eine Steuereinheit des Submoduls an die übergeordnete Steuerung des Stromrichters gesendet. Die übergeordnete Steuerung des Stromrichters kann somit erfassen, wann in einem bestimmten Submodul ein Bypassschalter gezündet wurde, und dieses Submodul somit nicht mehr für den Betrieb zur Verfügung steht. Somit kann einerseits der Betrieb der verbleibenden Submodule, insbesondere hinsichtlich der bereitzustellenden Spannungsstufen, an die Abwesenheit des Submoduls, von welchem das Zündsignal gesendet wurde, angepasst werden. Andererseits kann die übergeordnete Steuerung des Stromrichters feststellen, dass ggf. bei einem Fehler in einem weiteren Submodul der Betrieb auch bei einer Überbrückung des betreffenden Submoduls nicht mehr sicher ist, da eine Mindestanzahl aktiver Submodule für den sicheren Betrieb sonst unterschritten würde, und in einem solchen erneuten Fehlerfall den Betrieb des Stromrichters entsprechend unterbrechen.

Die Erfindung nennt weiter einen modularen Multilevel-Stromrichter, welcher eine Anzahl an Phasensträngen aufweist, wobei wenigstens ein Phasenstrang eine Reihenschaltung einer Mehrzahl von Submodulen nach einem der vorhergehenden Ansprüche umfasst. Bevorzugt ist hierbei in der Reihenschaltung die jeweils zweite Eingangsklemme eines Submoduls mit der jeweils ersten Eingangsklemme eines in Reihe nachfolgenden Submoduls mindestens schaltbar verbunden. Die für das Submodul und seine Weiterbildungen angegebenen Vorteile können hierbei sinngemäß auf den modularen Multilevel-Umrichter übertragen werden.

Nachfolgend wird ein Ausführungsbeispiel der Erfindung anhand einer Zeichnung näher erläutert. Hierbei zeigen jeweils schematisch:
- FIG 1: ein Schaltbild eines modularen Multilevel-Stromrichters,
- FIG 2: ein Schaltbild eines Doppelsubmoduls des Stromrichters nach FIG 1 mit einem Bypassschalter, und
- FIG 3: eine Schrägansicht zweier Doppelsubmodule mit einem Bypassschalter.

Einander entsprechende Teile und Größen sind in allen Figuren jeweils mit gleichen Bezugszeichen versehen.

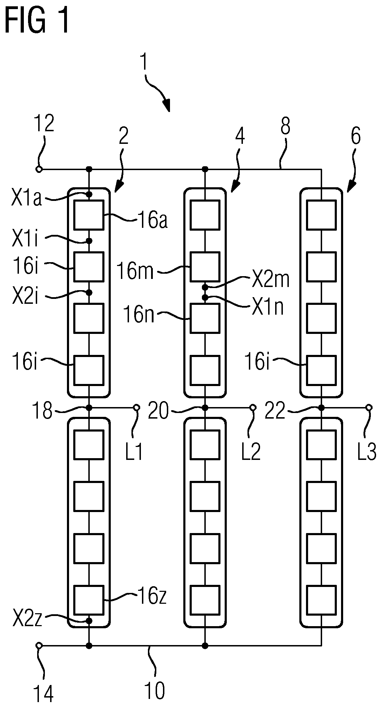

In FIG 1 ist in einer schematischen Darstellung ein vereinfachtes Schaltbild eines modularen Multilevel-Stromrichters 1 gezeigt. Der Stromrichters 1 weist drei Phasenstränge 2, 4, 6 auf, welche zwischen den beiden Verbindungsleitern 8, 10 parallel geschaltet sind. Der Verbindungsleiter 8 führt zum ersten Eingangskontakt 12, der Verbindungsleiter 10 führt zum zweiten Eingangskontakt 14. Der erste Eingangskontakt 12 und der zweite Eingangskontakt 14 sind im Betrieb der Stromrichterschaltung 1 an den positiven bzw. negativen Pol einer in der Zeichnung nicht näher dargestellten Gleichspannungsquelle angeschlossen.

Jeder der Phasenstränge 2, 4, 6 weist im Ausführungsbeispiel acht in Reihe geschaltete Submodule 16i auf. An der Verbindung zwischen des jeweils vierten und fünften Submoduls eines Phasenstranges 2, 4, 6 werden an den Kontaktpunkten 18, 20, 22 die jeweiligen Phasenspannungen L1 bzw. L2 bzw. L3 abgegriffen.

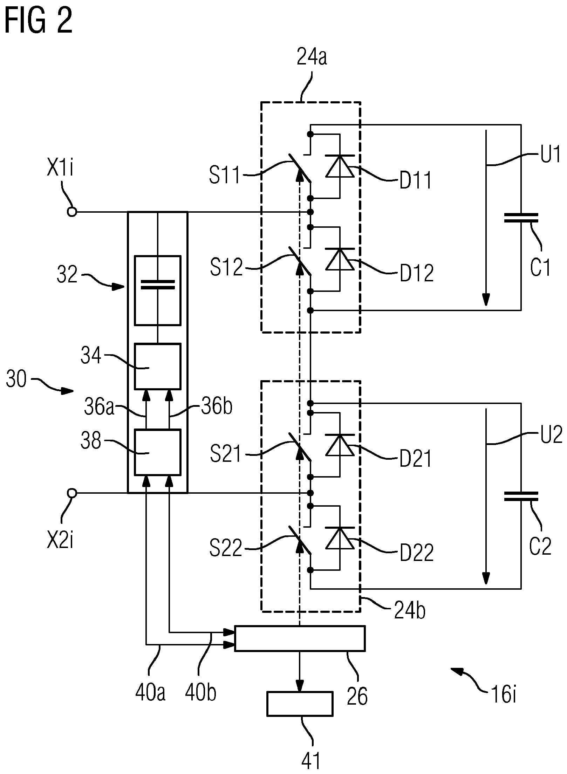

Jede der Zellen bzw. jedes der Submodule 16i weist eine erste Eingangsklemme X1i und eine zweite Eingangsklemme X2i auf, wobei in der jeweiligen Reihenschaltung die zweite Eingangsklemme X2m eines Submoduls 16m mit der ersten Eingangsklemme X1n eines in Reihe nachfolgenden Submoduls 16n verbunden ist. Die erste Eingangsklemme X1a des ersten Submoduls 16a eines jeden Phasenstranges 2, 4, 6 ist mit dem Verbindungsleiter 8 verbunden, welcher zum Eingangskontakt 12 führt. Die zweite Eingangsklemme X2z des letzten Submoduls 16z eines jeden Phasenstranges 2, 4, 6 ist mit dem Verbindungsleiter 10 verbunden, welcher zum Eingangskontakt 14 führt. Die Ausgestaltung der einzelnen Submodule 16i ist in FIG 2 beschrieben.

In FIG 2 ist in einer schematischen Darstellung ein vereinfachtes Schaltbild eines Submoduls 16i gezeigt. Das Submodul 16i weist eine erste Halbbrücke 24a und eine zweite Halbbrücke 24b auf. Die erste Halbbrücke 24a umfasst zwei Schalter S11, S12 und zu diesen jeweils parallele Freilaufdioden D11, D12, die zweite Halbbrücke 18b umfasst zwei Schalter S21, S22 und zu diesen jeweils parallele Freilaufdioden D21, D22. Eingangsseitig ist die erste Halbbrücke 24a mit der ersten Eingangsklemme X1i und mit der zweiten Halbbrücke 24b verschaltet. Die zweite Halbbrücke 24b ist eingangsseitig des Weiteren mit der zweiten Eingangsklemme X2i verschaltet. Ausgangsseitig ist die erste Halbbrücke 24a mit einer ersten Kapazität C1 verbunden. Die zweite Halbbrücke 24b ist ausgangsseitig mit einer zweiten Kapazität C2 verbunden. Über den Kapazitäten C1, C2 fallen jeweils die Teilspannungen U1 bzw. U2 ab. Durch einen Schaltzustand der Schalter S11, S12, S21, S22 können dabei die Kapazitäten C1, C2 bezügliche der ersten Eingangsklemme X1i und der zweiten Eingangsklemme X2i zueinander in Reihe geschaltet werden.

Das Submodul 16i weist eine Steuerplatine 26 auf, welche dazu eingerichtet ist, im Betrieb des Stromrichters die einzelnen Schalter S11, S12, S21, S22 anzusteuern. Des Weiteren ist die Steuerplatine 26 dazu eingerichtet, einen Fehler in den Schaltern S11, S12, S21, S22 oder den Kapazitäten C1, C2, beispielsweise eine Überspannung zu erfassen. Im Fall eines derartigen Fehlers kann das Submodul 16i über den Bypassschalter 30 zwischen der ersten Eingangsklemme X1i und der zweiten Eingangsklemme X2i kurzgeschlossen werden.

Der Bypassschalter 30 weist hierfür eine Vakuumschaltröhre 32 auf, welche durch ein pyrotechnisches Kraftelement 34 gezündet werden kann. Zur Zündung des pyrotechnischen Kraftelements 34 sind dabei zwei redundante Zündkreise 36a, 36b vorgesehen, welche jeweils von einer Steuerplatine 38 des Bypassschalters 30 aus zu initiieren sind. Registriert nun die Steuerplatine 26 des Submoduls 16i einen Fehler, kann über einen der voneinander getrennten Steuerkanäle 40a, 40b die Steuerplatine 38 des Bypassschalters 30 angesteuert werden, so dass diese über einen der Zündkreise 36a, 36b die Zündung des pyrotechnischen Kraftelements 34 steuert. Das pyrotechnische Kraftelement 34 schließt dann nach Zünden einen Schaltkontakt der Vakuumschaltröhre 32, wodurch die erste Eingangsklemme X1i mit der zweiten Eingangsklemme X2i kurzgeschlossen ist. Dadurch, dass zur Ansteuerung der Steuerplatine 38 des Bypassschalters 30 durch die Steuerplatine 26 des Submoduls 16i zwei voneinander getrennte, redundante Steuerkanäle 40a, 40b vorgesehen sind, wird hierbei die Verlässlichkeit des Bypassschalters 30 erhöht, da im Fehlerfall ein Ausfall beider Steuerkanäle 40a, 40b als sehr unwahrscheinlich einzustufen ist. Vergleichbares gilt für die beiden redundanten Zündkreise 36a, 36b zur Zündung des pyrotechnischen Kraftelements.

Im Falle der Zündung des pyrotechnischen Kraftelements 34 kann über einen der beiden Steuerkanäle 40a, 40b ein Zündsignal an die Steuereinheit 26 des Submoduls 16i gesendet werden, welche das Zündsignal über einen optischen Kanal, welcher für die Ansteuerung des Submoduls 16i durch die übergeordnete Steuerung 41 des Stromrichters vorgesehen ist, an die übergeordnete Steuerung 41 weiterleitet. Somit kann die übergeordnete Steuerung 41 den Betrieb der verbleibenden Submodule des Stromrichters an das durch die Überbrückung verursachte Ausfallen des betreffenden Submoduls 16i anpassen. Zudem kann die übergeordnete Steuerung 41 bei einem erneuten Fehler in einem weiteren Submodul den Betrieb des Stromrichters sicherheitshalber unterbrechen.

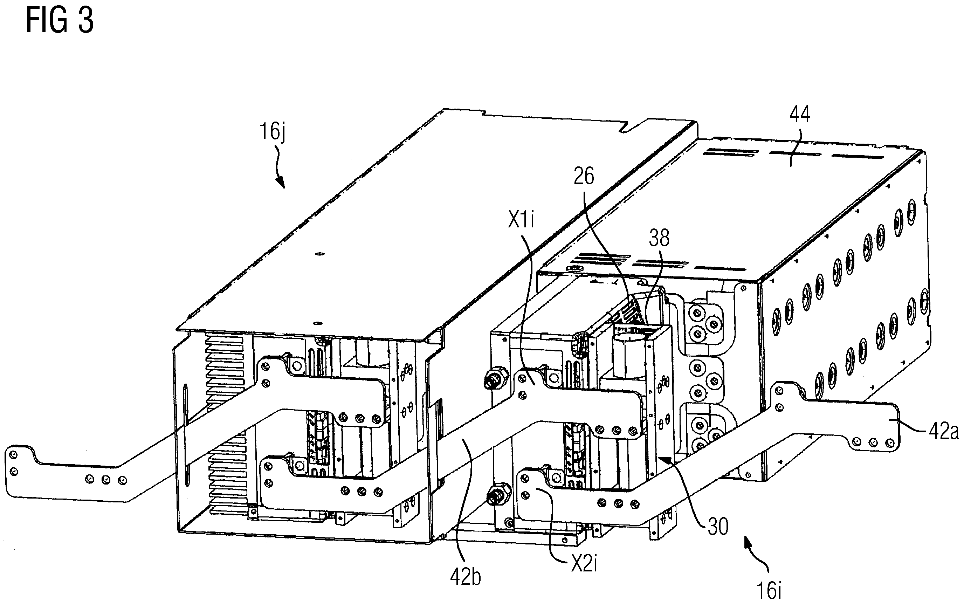

In FIG 3 ist in einer Schrägansicht ein Submodul 16i dargestellt. Das Submodul 16i ist an der ersten Eingangsklemme mit einer Verschienung 42a und an der zweiten Eingangsklemme X2i mit einer Verschienung 42b verbunden. Schematisch ist gezeigt, wie die Verschienung 42b die Verbindung zum nächsten Submodul 16j herstellt. Zwischen die Verschienungen 42a und 42b, welche an der ersten Eingangsklemme X1i bzw. der zweiten Eingangsklemme X2i des Submoduls 16i angeschlossen sind, ist der Bypassschalter 30 geschaltet. Der Bypassschalter 30 ist hierbei an Verschienungen 42a und 42b des Submoduls 16i befestigt. Die Verbindung der Steuerplatine 26 des Submoduls 16i mit der Steuerplatine 38 des Bypassschalters 30 erfolgt über ein nicht näher gezeigtes mehrkanaliges Kabel. Die Kapazitäten des Submoduls 16i sind in einem Gehäuse 44 angeordnet. Dadurch, dass der Bypassschalter 30 nicht in das Gehäuse 44 eingebracht und baulich von der Steuerplatine 26 des Submoduls 16i getrennt ist, wird ein Austausch des Bypassschalters 30 erheblich vereinfacht.

Obwohl die Erfindung im Detail durch das bevorzugte Ausführungsbeispiel näher illustriert und beschrieben wurde, ist die Erfindung nicht durch dieses Ausführungsbeispiel eingeschränkt. Andere Variationen können vom Fachmann hieraus abgeleitet werden, ohne den Schutzumfang der Erfindung zu verlassen, wie er durch die beigefügten Ansprüche definiert wird.

## Patentansprüche

1. Submodul (16a-16z) insbesondere für einen modularen Multilevel-Stromrichter (1), welches eine erste Eingangsklemme (X1i) und eine zweite Eingangsklemme (X2i) sowie einen Bypassschalter (30) aufweist,
wobei das Submodul (16a-16z) eine erste Halbbrücke (24a) und eine erste Kapazität (C1) umfasst,
wobei die erste Halbbrücke (24a) eingangsseitig mit der ersten Eingangsklemme (X1i) und ausgangsseitig mit der ersten Kapazität (C1) verschaltet ist,
wobei das Submodul (16a-16z) eine zweite Halbbrücke (24b) und eine zweite Kapazität (C2) umfasst,
wobei die zweite Halbbrücke (24b) eingangsseitig mit der zweiten Eingangsklemme (X2i) und ausgangsseitig mit der zweiten Kapazität (C2) derart verschaltetet ist, dass durch einen gemeinsamen Schaltzustand der ersten Halbbrücke (24a) und der zweiten Halbbrücke (24b) die erste Kapazität (C1) und die zweite Kapazität (C2) in Reihe zur ersten Eingangsklemme (X1i) und zur zweiten Eingangsklemme (X2i) schaltbar sind wobei die erste Eingangsklemme (X1i) und die zweite Eingangsklemme (X2i) durch Schließen des Bypassschalters (30) kurzschließbar sind, und
wobei der Bypassschalter (30) ein pyrotechnisches Kraftelement (34) aufweist, welches dazu eingerichtet ist, durch Zündung den Schaltweg im Bypassschalter (30) zu schließen.

2. Submodul (16a-16z) nach Anspruch 1,
wobei der Bypassschalter (30) eine Vakuumschaltröhre (32) umfasst, durch welche der Schaltweg im Bypassschalter (30) schließbar ist.

3. Submodul (16a-16z) nach Anspruch 1 oder Anspruch 2,
wobei der Bypassschalter (30) wenigstens zwei redundante Zündkreise (36a, 36b) zum Zünden des pyrotechnischen Kraftelements (34) aufweist.

4. Submodul (16a-16z) nach einem der vorhergehenden Ansprüche,
wobei das Submodul (16a-16z) und der Bypassschalter (30) jeweils eine Steuerplatine (26, 38) umfassen, und
wobei die Steuerplatine (26) des Bypassschalters (30) über wenigstens zwei redundante Steuerkanäle (40a, 40b) von der Steuerplatine (26) des Submoduls (16a-16z) angesteuert werden kann.

5. Submodul (16a-16z) nach einem der vorhergehenden Ansprüche,
wobei der Bypassschalter (30) dazu eingerichtet ist, beim Zünden des pyrotechnischen Kraftelements (34) wenigstens ein Zündsignal an eine übergeordnete Steuerung (41) des Stromrichters (1) auszusenden.

6. Modularer Multilevel-Stromrichter (1), welcher eine Anzahl an Phasensträngen (2, 4, 6) aufweist,
wobei wenigstens ein Phasenstrang (2, 4, 6) eine Reihenschaltung einer Mehrzahl von Submodulen (16a-16z) nach einem der vorhergehenden Ansprüche umfasst.

## Claims

1. Submodule (16a-16z) in particular for a modular multilevel power converter (1), which has a first input terminal (X1i) and a second input terminal (X2i) as well as a bypass switch (30),
wherein the submodule (16a-16b) comprises a first half bridge (24a) and a first capacitor (C1),
wherein the first half bridge (24a) is connected on the input side to the first input terminal (X1i) and on the output side to the first capacitor (C1),
wherein the submodule (16a-16z) comprises a second half bridge (24b) and a second capacitor (C2),
wherein the second half bridge (24b) is connected on the input side to the second input terminal (X2i) and on the output side to the second capacitor (C2) such that by means of a shared switching state of the first half bridge (24a) and the second half bridge (24b) the first capacitor (C1) and the second capacitor (C2) can be connected in series with the first input terminal (X1i) and the second input terminal (X2i)
wherein the first input terminal (X1i) and the second input terminal (X2i) can be short-circuited by closing the bypass switch (30) and
wherein the bypass switch (30) has a pyrotechnical force element (34), which is designed to close the switching path in the bypass switch (30) by means of ignition.

2. Submodule (16a-16z) according to claim 1,
wherein the bypass switch (30) comprises a vacuum switching tube (32), by means of which the switching path in the bypass switch (30) can be closed.

3. Submodule (16a-16z) according to claim 1 or claim 2,
wherein the bypass switch (30) has at least two redundant ignition circuits (36a, 36b) for igniting the pyrotechnical force element (34).

4. Submodule (16a-16z) according to one of the preceding claims,
wherein the submodule (16a-16z) and the bypass switch (30) each comprise a control board (26, 28) and
wherein the control board (26) of the bypass switch (30) can be activated by way of at least two redundant control channels (40a, 40b) by the control board (26) of the submodule (16a-16z).

5. Submodule (16a-16z) according to one of the preceding claims,
wherein the bypass switch (30) is designed to transmit at least one ignition signal to a higher-ranking controller (41) of the power converter (1) upon ignition of the pyrotechnical force element (34).

6. Modular multilevel power converter (1), which has a number of phase strands (2, 4, 6),
wherein at least one phase strand (2, 4, 6) comprises a series circuit comprising a plurality of submodules (16a-16z) according to one of the preceding claims.

## Revendications

1. Sous-module (16a-16z), notamment pour un convertisseur (1) modulaire à niveaux multiples, qui a une première borne (X1i) d'entrée et une deuxième borne (X2i) d'entrée ainsi qu'un interrupteur (30) en dérivation,
dans lequel le sous-module (16a-16z) comprend un premier demi-pont (24a) et une première capacité (C1),
dans lequel le premier demi-pont (24a) est relié, du côté de l'entrée, à la première borne (X1i) d'entrée et, du côté de la sortie, à la première capacité (C1),
dans lequel le sous-module (16a-16z) comprend un deuxième demi-pont (24b) et une deuxième capacité (C2),
dans lequel le deuxième demi-pont (24b) est relié, du côté de l'entrée, à la deuxième borne (X2i) d'entrée et, du côté de la sortie, à la deuxième capacité (C2), de manière à ce que, par un état de commutation commun du premier demi-pont (24a) et du deuxième demi-pont (24b), la première capacité (C1) et la deuxième capacité (C2) puissent être montées en série par rapport à la première borne (X1i) d'entrée et par rapport à la deuxième borne (X2i) d'entrée,
dans lequel la première borne (X1i) d'entrée et le deuxième borne (X2i) d'entrée peuvent être court-circuitées par fermeture de l'interrupteur (30) en dérivation et
dans lequel l'interrupteur (30) en dérivation a un élément (34) de force pyrotechnique propre à fermer, par allumage, le chemin d'interruption dans l'interrupteur (30) en dérivation.

2. Sous-module (16a-16z) suivant la revendication 1,
dans lequel l'interrupteur (30) en dérivation comprend un tube (32) d'interrupteur à vide, par lequel le trajet de commutation, dans l'interrupteur (30) en dérivation, peut être fermé.

3. Sous-module (16a-16z) suivant la revendication 1 ou la revendication 2,
dans lequel l'interrupteur (30) en dérivation a au moins deux circuits (36a, 36b) redondants d'allumage pour allumer l'élément (34) de force pyrotechnique.

4. Sous-module (16a-16z) suivant l'une des revendications précédentes,
dans lequel le sous-module (16a-16z) et l'interrupteur (30) en dérivation ont chacun une platine (26, 38) de commande et
la platine (26) de commande de l'interrupteur (30) en dérivation peut être commandée par l'intermédiaire d'au moins deux canaux (40a, 40b) de commande redondants par la platine de commande du sous-module (16a-16z).

5. Sous-module (16a-16z) suivant l'une des revendications précédentes,
dans lequel l'interrupteur (30) en dérivation est conçu pour, lors de l'allumage de l'élément (34) de force pyrotechnique, envoyer au moins un signal d'allumage à une commande (41) supérieure hiérarchiquement du convertisseur (1).

6. Convertisseur (1) modulaire à niveaux multiples, qui a un certain nombre de conducteurs (2, 4, 6) de phase,
dans lequel au moins un conducteur (2, 4, 6) de phase comprend un circuit série d'une pluralité de sous-modules (16a-16z) suivant l'une des revendications précédentes.
